Europäisches Patentamt

(19) European Patent Office

Office européen des brevets

(11) Numéro de publication: **0 038 762**
**B1**

(12) **FASCICULE DE BREVET EUROPEEN**

(45) Date de publication du fascicule du brevet: **12.09.84**

(21) Numéro de dépôt: **81400630.0**

(22) Date de dépôt: **21.04.81**

(51) Int. Cl.³: **H 03 K 13/05,** H 03 K 13/17

(54) Codeur analogique-numérique comportant un générateur de tension codée à transfert de charges.

(30) Priorité: **23.04.80 FR 8009113**

(43) Date de publication de la demande:
**28.10.81 Bulletin 81/43**

(45) Mention de la délivrance du brevet:
**12.09.84 Bulletin 84/37**

(84) Etats contractants désignés:
**DE GB NL**

(56) Documents cités:
**FR-A-2 336 834**
**FR-A-2 351 544**
**US-A-3 938 188**

(73) Titulaire: **THOMSON-CSF**
**173, Boulevard Haussmann**
**F-75379 Paris Cedex 08 (FR)**

(72) Inventeur: **Benoit-Gonin, Roger**
**Thomson-CSF SCPI 173, bld Haussmann**
**F-75360 Paris Cedex 08 (FR)**
Inventeur: **Berger, Jean-Luc**
**Thomson-CSF SCPI 173, bld Haussmann**
**F-75360 Paris Cedex 08 (FR)**
Inventeur: **Coutures, Jean-Louis**
**Thomson-CSF SCPI 173, bld Haussmann**
**F-75360 Paris Cedex 08 (FR)**

(74) Mandataire: **Mayeux, Michèle et al**
**THOMSON-CSF SCPI 173, Bld Haussmann**
**F-75379 Paris Cedex 08 (FR)**

Courier Press, Leamington Spa, England.

## 0 038 762

### Description

La présente invention concerne un codeur analogique-numérique comportant un générateur de tension codée à transfert de charges.

Il est bien connu dans l'art antérieur de déterminer par approximations successives les coefficients $a_0, a_1...a_i...a_n$, égaux à 0 ou à 1, qui permettent de coder en digital une tension analogique $V_x$ inconnue en l'écrivant sous la forme:

$$|V_x| = a_0.V_R + a_1.V_R/2 + a_2.V_R/2^2 + ... + a_i.V_R/2^i + ... + a_n.V_R/2^n,$$

où $V_R$ est une tension de référence.

Pour cela,

— $|V_x|$ est tout d'abord comparée à $V_R$. Si $|V_x|$ est inférieure à $V_R$, alors $a_0$ égale 0, sinon égale 1;
— $|V_x|$ est ensuite comparée à $V_{R1} = a_0V_R + V_R/2$. Si $|V_x|$ est inférieure à $V_{R1}$, alors $a_1$ égale 0, sinon $a_1$ égale 1;
— puis $|V_x|$ est comparée à $V_{R2} = a_0V_R + a_1.V_R/2 + V_R/4$. Si $|V_x|$ est inférieure à $V_{R2}$, alors $a_2$ égale 0, sinon $a_2$ égale 1;

et ainsi de suite jusqu'à ce que tous les coefficients $a_0...a_n$ soient déterminés.

On constate donc qu'il est nécessaire pour déterminer par approximations successives les coefficients $a_0...a_n$ de disposer des tensions $V_R$ et

$$V_{Ri} = a_0V_R + a_1.V_R/2 + a_2.V_R/2^2 + ... + a_{i-1}.V_R/2^{i-1} + V_R/2^i$$

avec $i = 1...n$.

Par le document FR—A—2.336.834, on connait un codeur analogique-numérique comportant un générateur de tension codée à transfert de charge dans lequel il y a détermination par approximations successives des coefficients $a_0...a_n$, égaux à 0 ou à 1, et tel que la tension à coder $V_x$ s'écrive:

$$|V_x| = a_0.V_R + a_1.V_R/2 + a_2.V_R/2^2 + ... + a_n.V_R/2^n,$$

où $V_R$ est une tension de référence.

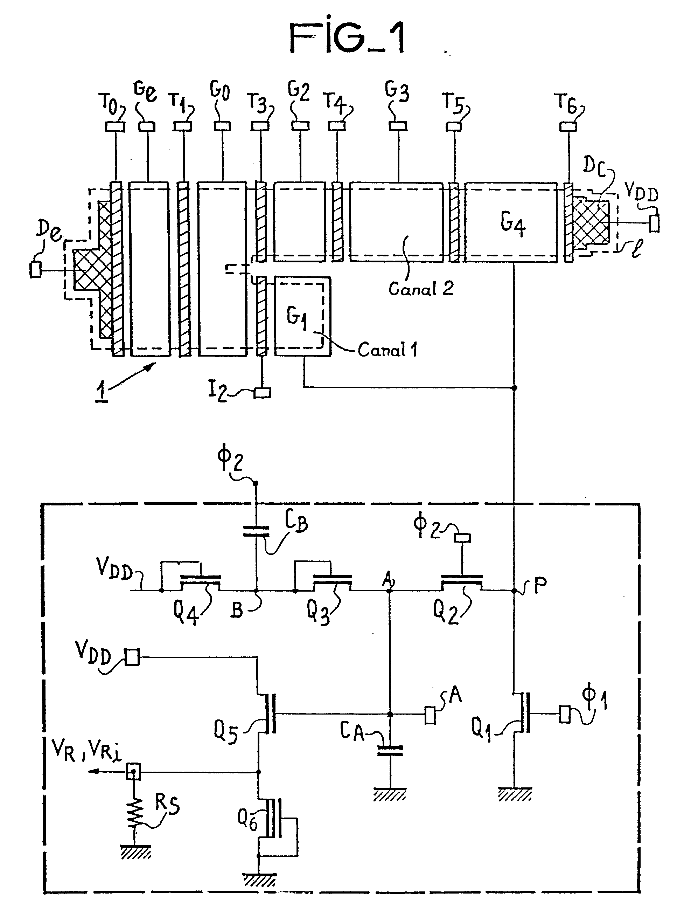

Le demande de brevet européen n° 80 401 781.2 (EP—A1—3175) fait partie de l'état de la technique tel qu'il est défini à l'article 54, paragraphe 3 et concerne un générateur de tension codée à transfert de charges, oui est représenté sur la figure 1, et qui sera décrit de façon détaillée ultérieurement. Ce générateur fournit les tensions $V_R$ et $V_{Ri}$.

Une quantité de charges de référence $2Q_R$ est injectée dans le générateur au début du traitement de chaque échantillon $|V_x|$. Ce générateur est constitué par un dispositif à transfert de charges (DTC) qui se divise en deux cannaux parallèles. Dans chaque canal on recueille la moitié de la charge se trouvant dans le DTC avant la division.

Un dispositif de lecture des charges (DLC) est relié aux deux canaux: à la grille de stockage $G_1$ suivant la division pour le premier canal et à la troisième grille de stockage $G_4$ suivant la division pour le deuxième canal.

Le DLC recueille donc d'abord la quantité de charges $Q_R$ se trouvant sous $G_1$ et fournit la tension $V_R$. Le coefficient $a_0$ peut donc être déterminé.

Si $a_0 = 0$, la quantité de charges $Q_R$ stockée dans le deuxième canal est évacuée, si $a_0 = 1$, cette quantité de charges est mise en mémoire sous la deuxième grille de stockage $G_3$ suivant la division du DTC.

Dans tous les cas, la quantité de charge $Q_R$ stockée sous la grille $G_1$ du premier canal fait un aller-retour de part et d'autre de la zone où le DTC se divise en deux canaux et ainsi une quantité de charges $Q_R/2$ est stockée sous les grilles $G_1$ et $G_2$.

Ainsi, après transfert du contenu éventuel de $G_3$ que nous appellerons $a_0Q_R$ sous $G_4$, le DLC recueille une quantité de charges égale à: $a_0Q_R + Q_R/2$ et fournit donc $V_{R1}$ qui permet de déterminer $a_1$; et ainsi de suite jusqu'à la détermination de $a_n$ après l'élaboration de $V_{Rn}$.

Les problèmes qui se posent lorsqu'on veut réaliser un codeur analogique-numérique avec le générateur de tension codée à transfert de charges dont il vient d'être question sont les suivants:

— le générateur de tension codée possède les défauts propres aux dispositifs à transfert de charges, qui sont essentiellement: l'inefficacité de transfert, le courant d'obscurité et les courants de fuite résultant de défauts cristallins ou d'impuretés d'interface (et propres surtout aux DTC à transfert en surface). Or l'importance de ces défauts augmente dans le cas du générateur de tension codée où on fait subir à une quantité de charges initiale $2Q_R$, n allers-retours de part et d'autre de la division du DTC pour finalement obtenir $Q_R/2^n$ et où le temps de stockage de cette quantité de charges est donc relativement important. En ce qui concerne l'inefficacité de transfert, on peut utiliser des DTC

2

# 0 038 762

à canal enterré dont le coefficient de transfert est sensiblement égal à 1, à quelques unités $10^{-5}$ près. Par contre, en ce qui concerne les courants d'obscurité et de fuites, on est obligé de limiter le nombre n de divisions successives qu'on peut faire valablement en conservant une charge finale parfaitement différenciée du bruit de fond thermique;

— les tensions de décalages qui apparaissent au niveau de tous les organes actifs adjoints au générateur pour réaliser le codeur, en particulier lorsqu'on fait appel pour la réalisation de ces organes à des technologies de type MOS.

La présente invention permet de résoudre ces problèmes.

Le codeur analogique-numérique selon l'invention comporte un générateur de tension codée à transfert de charges, élaborant des tension $V_R$, $V_{Ri} = a_0 V_R + a_1 . V_R/2^2 + \dots a_n . V_R/2^n$, où $V_R$ est une tension de référence, ces tensions permettant par comparaison avec la tension à coder $V_x$ de déterminer par approximations successives les coefficients $a_0 \dots a_n$, égaux à 0 ou à 1 et tels que

$$|V_x| = a_0 V_R + a_1 . V_R/2 + a_2 . V_R/2^2 \dots + a_n . V_R/2^n,$$

caractérisé en ce que ce générateur est constitué par un dispositif à transfert de charges comportant en alternance des grilles de stockage et des grilles de transfert, avec:

— à une extrémité de la zone active où s'effectuent le transfert et le stockage des charges, une diode qui assure, au début du traitement de chaque échantillon de la tension à coder $V_x$, l'injection d'une quantité de charges de références $2Q_R$ et qui assure aussi l'évacuation des charges en surplus au cours du traitement;

— une diffusion d'isolement qui partage en deux parties égales les charges en provenance d'une première grille de stockage située du côté de la diode et qui divise la zone active après la première grille de stockage en deux canaux parallèles;

— sur l'un desdits canaux, une deuxième grille de stockage sous laquelle se trouvent stockées par des allers-retours successifs entre la première grille de stockage et la deuxième grille de stockage, les quantités de charges $Q_R$, $Q_R/2 \dots$

— sur l'autre desdits canaux, une troisième, quatrième et cinquième grilles de stockage, la quantité de charges $Q_R/2^i$ stockée sous la troisième grille de stockage en provenance de la première grille de stockage étant transférée sous la première grille de stockage puis évacuée sous la diode lorsque $a_i$ est nul, pour $i = 0..n$, et étant transférée sous la quatrième grille de stockage lorsque $a_i$ égale 1; un dispositif de lecture des charges relié aux deuxième et cinquième grilles de stockage qui assure l'élaboration de $V_R$ lors du transfert de $Q_R$ sous la deuxième grille de stockage ce qui permet la détermination de $a_0$ par comparaison de $V_R$ avec $V_x$, puis l'élaboration de $V_{R1} = a_0 Q_R + Q_R/2$, lors du transfert de $Q_R/2$ sous la deuxième grille de stockage et lors de l'éventuel transfert, si $a_0 = 1$, de $Q_R$ en provenance de la quatrième grille de stockage vers la cinquième grille de stockage ce qui permet la détermination de $a_1$ par comparaison de $V_{R1}$ avec $V_x$, et ainsi de suite et en ce que la détermination par approximation successives des coefficients $a_0 \dots a_n$, se fait en deux étapes:

— au cours de la première étape, après injection d'une quantité de charges de référence $2 Q_R$, le générateur élabore les tensions

$$V_R \text{ et } V_{Ri} = a_0 . V_R + a_1 . V_R/2 + \dots a_{i-1} . V_R/2^{i-1} + V_R/2^i, \text{ avec } i = 1 \text{ à } k-1;$$

— au cours de la deuxième étape, après injection d'une nouvelle quantité de charges de référence $2 Q_R$, le générateur élabore les tensions $V_R$ et $V_{Ri}$ avec $i = 1$ à $n-k$, le codeur comportant des moyens assurant d'une part la division par $2^k$ des tensions élaborés au cours de la deuxième étape et d'autre part leur sommation avec la dernière tension $V_{R(k-1)}$ produite lors de la première étape.

Ainsi selon l'invention, en choisissant $k = (n+1)/2$, on divise par deux le nombre d'allers-retours de la quantité de charges de référence $2Q_R$ qui est initialement introduite dans le générateur et on divise par deux le temps de stockage dans le DTC de cette quantité de charges; il faut remarquer que le codage de chaque échantillon $|V_x|$ demande l'injection successive dans le générateur de deux quantités de charges de référence: $2Q_R$.

L'invention permet d'obtenir un codeur présentant une précision accrue ou permet d'utiliser des DTC moins performants en ce qui concerne l'inefficacité de transfert, les courants d'obscurité et de fuite.

Enfin, selon un mode de réalisation préféré, le codeur selon l'invention effectue une compensation des tensions de décalage qui apparaissent au niveau des organes actifs.

D'autres objets, caractéristiques et résultats de l'invention ressortiront de la description suivante, donnée à titre d'exemple non limitatif et illustrée par les figures annexées qui représentent:

— la figure 1, une vue de dessus du générateur de tension codée à transfert de charges et le schéma électrique du dispositif de lecture des charges (DLC) qui lui est associé, ce générateur et ce DLC étant utilisés dans le codeur selon l'invention;

3

— la figure 2, une représentation schématique.
du codeur analogique-numérique selon l'invention.

Sur les différentes figures, les mêmes repères désignent les mêmes éléments, mais, pour des raisons de clarté, les cotes et proportions des différents éléments ne sont pas respectées.

La figure 1 représente une vue de dessus du dispositif à transfert de charges constituant le générateur de tension codée utilisé dans le codeur selon l'invention, ainsi que le schéma électrique du dispositif de lecture des charges, appelé dans ce qui suit D.L.C., qui lui est associé.

Ce dispositif de transfert de charges est préférentiellement du type C.C.D. (Charge Coupled Device). Le transfert des charges peut se faire en surface ou en volume. Enfin, ce dispositif peut être à canal enterré ou non. La description suivante concerne le cas d'un DTC à canal N créé par surdopage $P^+$ d'un substrat de type P; dans ce cas, les signaux d'horloge évoluent entre le niveau zéro et un niveau haut positif. Il serait bien sûr possible de réaliser le DTC avec un canal P dans un substrat de type N.

La zone active du substrat semiconducteur où s'effectuent le transfert et le stockage des charges se situe à l'intérieur de la ligne l en trait discontinu. A l'extérieur de la zone délimitée par cette ligne, un surdopage du substrat élève le seuil d'inversion et s'oppose ainsi à tout stockage des charges.

A une extrémité de la zone active, l'extrêmité gauche sur la figure, on trouve une diode $D_e$ qui permet d'introduire une charge de référence $2Q_R$ sous une grille de stockage $G_e$ par l'intermédiaire d'une grille de transfert $T_0$. La diode $D_e$ et les grilles $T_0$ et $G_e$ constituent le dispositif d'injection de la charge de référence $2Q_R$ dans le générateur qui est globalement repéré par la référence 1 sur la figure.

La diode $D_e$ est également utilisée pour l'évacuation des charges en surplus au cours du fonctionnement du générateur.

La grille $G_e$ est suivie d'une grille de transfert $T_1$ et d'une grille de stockage $G_0$.

Sous $G_0$, une diffusion d'isolement s'avance, à la moitié de la largeur de la zone active de transfert des charges pour effectuer une pré-partage de la charge stockée sous $G_0$ en deux quantités de charges égales. Cette diffusion d'isolement divise la zone active après $G_0$ en deux canaux parallèles, généralement de même largeur. Ainsi sous les grilles de stockage $G_1$ et $G_2$, situées sur chaque canal après $G_0$ et séparées de $G_0$ par les grilles de transfert $T_2$ et $T_3$, seront transférées deux quantités de charges égales à la moitié de la charge stockée sous $G_0$, ce partage d'une quantité de charges par une zone diffusée est connu de l'art antérieur.

L'un des canaux se termine donc par la grille de stockage $G_1$, tandis que l'autre canal comporte après la grille de stockage $G_2$ deux grilles de stockage $G_3$ et $G_4$ et trois grilles de transfert, $T_4$ entre $G_2$ et $G_3$ $T_5$ entre $G_3$ et $G_4$ et $T_6$ entre $G_4$ et une diode collectrice $D_c$. La diode collectrice $D_c$ qui termine le canal est reliée à une tension continue $V_{DD}$ et permet l'évacuation des charges en fin de traitement d'un échantillon $V_x$.

Les grilles $G_1$ et $G_4$ sont connectées en un point P au D.L.C. qui opère une lecture non destructive des charges stockées sous $G_1$ et $G_4$.

Ce dispositif de lecture peut être un dispositif de lecture des charges en courant connu dans l'art antérieur, tel par exemple celui qui est décrit par la demande de brevet français N° 77.13857 publiée sous le n° 2.389.899 au nom de THOMSON-CSF.

Le potentiel au point P est maintenu constant lors de l'arrivée des charges grâce à un transistor MOS $Q_2$, relié entre le point P et un point A. Le transistor $Q_2$, commandé par un signal d'horloge périodique $\phi_2$, se trouve alors polarisé en saturation. Le courant qui traverse $Q_2$ lors de l'afflux des charges est intégré dans une capacité $C_A$ reliée entre le point A et la masse.

La tension au point A est lue par un transistor MOS ou TMOS $Q_5$ monté en suiveur, dont la grille est reliée au point A, dont l'une des électrodes est reliée à une tension $V_{DD}$ et dont l'autre électrode fournit la tension de lecture aux bornes d'une résistance $R_s$ ou sur le drain d'un transistor MOS de charge $Q_6$. Le TMOS $Q_5$ peut être remplacé pour lire la tension au point A par un amplificateur opérationnel de gain 1 et d'impédance d'entrée élevée.

Entre le point A et un point B est également connecté un TMOS $Q_3$ dont la grille est reliée à B. Une capacité $C_8$ est reliée entre le point B et le signal d'horloge $\phi_2$. Enfin un TMOS $Q_4$ est relié entre le point B et la tension $V_{DD}$, la grille de $Q_4$ et aussi reliée à $V_{DD}$.

Enfin, un TMOS $Q_1$ est connecté entre les grilles $G_1$ et $G_4$ et la masse. Le TMOS $Q_1$ est commandé par un signal d'horloge périodique $\phi_1$ et provoque lorsqu'il conduit la remise à zéro des grilles auxquelles il est connecté.

Nous allons maintenant étudier le fonctionnement du générateur représenté sur la figure 1.

On peut distinguer cinq séquences dans ce fonctionnement:

— séquence $t_0$: une charge $2Q_R$ est introduite sous la grille $G_e$ de façon connue par la méthode dite "fill and spill". Pour cela, la diode $D_e$ est successivement portée à un niveau bas qui permet le passage des charges de $D_e$ sous $T_0$ et $G_e$, puis à un niveau haut qui permet de stocker sous $G_e$ une quantité de charges donnée $2Q_R$. Les grilles $T_0$ et $G_e$ reçoivent la même tension $V_{GE}$. La quantité de charges de référence $2Q_R$ est stable au premier ordre, c'est-à-dire indépendante des variations de la tension $V_{GE}$ appliquée à $T_0$ et $G_E$, si les courbes de potentiel de surface en fonction de la tension de ce couple de grilles sont parallèles. Pour cela, on ajuste les tensions seuils sous $T_0$ et $G_e$ par implantation sous $T_0$.

**0 038 762**

Les autres électrodes de transfert du générateur $T_1...T_6$ peuvent être réalisés sur une surépaisseur d'oxyde. Elles peuvent aussi comme $T_0$ être réalisées par implantation ou être réalisées de toute autre façon connue.

— séquence $t_1$: la charge $2Q_R$ est transférée sous $G_0$. Le signal d'horloge $\phi_2$ est au niveau haut $V_\phi$ de sorte que le point B initialement préchargé par $Q_4$ à $V_{DD}-V_T$ passe à $V_B=V_{DD}-V_T+V_\phi$, et le point A est porté par $Q_3$ à $V_B-V_T$, où $V_T$ est la tension de seuil commune aux TMOS $Q_2$, $Q_3$ et $Q_4$. Le point P et les grilles $G_1$ et $G_4$ sont pré-chargés à $V_\phi-V_T$; le TMOS $Q_2$ se trouve polarisé en saturation car le potentiel du point A $V_{A0}=V_B-V_T$ est supérieur à celui du point P $V_\phi-V_T$.

— séquence $t_2$: la charge $2Q_R$ présente sous $G_0$ est transférée vers $G_1$ et $G_2$ par la mise à zéro de $G_0$ car les grilles $T_2$ et $T_3$ sont à des potentiels fixes intermédiaires. Les charges sont donc transférées par dessus les barrières de potentiel induites sous $T_2$ et $T_3$ ce qui supprime les parasites que pourrait produire la mise à zéro de $T_2$ et $T_3$ sur les grilles de lecture $G_1$ et $G_2$.

On dispose donc de la charge $Q_R$ sous $G_1$ et de la charge $Q_R$ sous $G_2$ à cause du partage des charges réalisé par la diffusion d'isolement.

Dans ce même temps, $T_4$ et $G_3$ sont mises à zéro et $T_5$ à un potentiel fixe intermédiaire ce qui correspond au transfert d'une charge éventuelle de $G_3$ vers $G_4$.

Lors de la première séquence $t_2$ il n'y a pas de charges à transférer de $G_3$ vers $G_4$ et c'est l'arrivée de $Q_R$ sous $G_1$ qui provoque seule le passage d'un courant à travers $Q_2$ qui maintient le potentiel au point P à $V_\phi-V_T$ en évacuant la charge du point P au point A ce qui fait que le potentiel en A passe de $V_{A0}$ à $V_A=V_{A0}-Q_R/C_A=V_{A0}-V_R$.

On dispose donc par l'intermédiaire du TMOS $Q_5$ monté en suiveur d'une tension $V_S$ proportionnelle à $V_R=Q_R/C_A$. La tension $V_R$ permet au codeur selon l'invention de fournir la valeur de $a_0$:

$$a_0=0 \text{ si } |V_x|<V_R$$

$$a_0=1 \text{ si } |V_x|>V_R$$

— séquence $t_3$: selon la valeur de $a_0$, les transferts de charges diffèrent:
— si $a_0=0$, la charge $Q_R$ est transférée de $G_2$ sous $G_0$ puis sous $G_e$ et elle est enfin évacuée par la diode $D_e$;
— si $a_0=1$, la charge $Q_R$ est transférée de $G_2$ sous $G_3$. La charge $a_0 Q_R$ se trouve donc stockée sous $G_3$;
— séquence $t_4$: le passage de $\phi_1$ au niveau haut, alors que $\phi_2$ passe au niveau bas, rend conducteur le TMOS $Q_1$ et provoque la remise à zéro de $G_1$, et donc le transfert de $Q_R$ de $G_1$ vers $G_0$, et la remise à zéro de $G_4$, et donc le transfert d'une charge éventuelle de $G_4$ vers $G_3$.

Les différentes séquences sont ensuite reprises à partir de la séquence $t_1$, la séquence $t_0$ n'a pas lieu puisqu'on dispose de la charge $Q_R$ sous $G_0$.

On a ainsi successivement:

— séquence $t_1$: pré-charge des points A et P
— séquence $t_2$:
— transfert de $Q_R/2$ sous $G_1$ et de $Q_R/2$ sous $G_2$;
— transfert de $a_0 Q_R$ de $G_3$ vers $G_4$;
— lecture de $a_0 Q_R+Q_R/2$;
— comparaison par le codeur de $V_{R1}=(a_0.Q_R+Q_R/2)/C_A$ avec $|V_x|$ et détermination de $a_1$.
— séquence $t_3$:
— si $a_1=0$, évacuation de $Q_R/2$ de $G_2$ vers $G_0$, $G_e$ et $D_e$;
— si $a_1=1$, transfert de $Q_R/2$ de $G_2$ sous $G_3$.
— séquence $t_4$:
— transfert de $Q_R/2$ de $G_1$ vers $G_0$;
— transfert de $a_0 Q_R$ de $G_4$ vers $G_3$. On trouve alors sous $G_3$ la charge $a_0 Q_R+a_1 Q_R/2$.

Les différentes séquences sont ensuite reprises à partir de $t_1$. Pour la détermination de chaque coefficient $a_i$, il faut donc une séquence de pré-charge $t_1$ et trois séquences $t_2$, $t_3$, $t_4$ de transfert successives donc certaines comportent plusieurs transferts simultanés.

Lorsque tous les coefficients ont été détermines, il y a évacuation des charges de $G_1$ vers $G_0$, $G_e$ et $D_e$ et des charges stockées sous $G_4$ vers $D_c$.

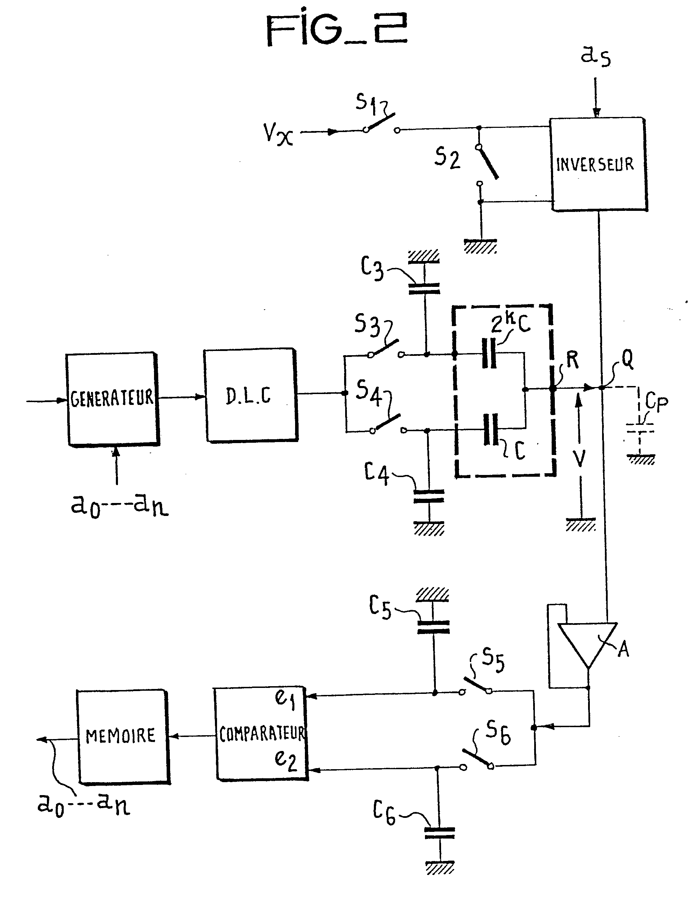

La figure 2 concerne une représentation schématique du codeur analogique-numérique selon l'invention.

Sur la figure 2, on trouve connectés en série le générateur de tension codée à transfert de charges et le D.L.C. qui viennent d'être décrits en relation avec la figure 1 et qui sont symbolisés par des rectangles.

5

Selon l'exemple choisi le DTC ayant un canal N, les charges recueillies au point A du DLC sont des électrons et correspondent donc à l'élaboration de tensions négatives $-V_R$ et $-V_{Ri}$.

La sortie du D.L.C. est réunie à deux échantillonneurs-bloqueurs qui sont représentés symboliquement par un interrupteur $S_3$ et $S_4$, suivi par une capacité connectée à la masse, $C_3$ et $C_4$.

Il est bien entendu que dans la pratique les interrupteurs des échantillonneurs-bloqueurs sont constitués de façon connue par un ou plusieurs transistors MOS fonctionnant en commutation.

Chaque échantillonneur-bloqueur est relié à l'une des deux entrées d'un diviseur de tension capacitif à deux voies. L'une des voies de ce diviseur, sur la figure 1 la voie supérieure qui suit l'interrupteur $S_3$ et la capacité $C_3$, comporte une capacité de valeur $2^k C$ alors que l'autre voie comporte une capacité de valeur C.

On appelle R la sortie du diviseur, c'est-à-dire le point commun aux deux capacités C et $2^k C$.

Il est connu de réaliser un tel diviseur capacitif sous forme intégrée et avec une bonne précision. Ainsi dans l'article paru dans la revue I.E.E.E. Journal of Solid-State Circuits, volome SC 10, n°6, décembre 1975, pages 371 à 379 des réseaux de capacités intégrées à valeurs pondérées sont utilisés dans des codeurs capacitifs à redistribution de charges.

Dans le codeur selon l'invention, la détermination des coefficients $a_0$ à $a_n$ permettant de coder chaque échantillon $V_x$ se fait en deux étapes.

Au cours de la première étape, l'interrupteur $S_3$ est fermé alors que l'interrupteur $S_4$ est ouvert.

On introduit dans le générateur la quantité de charges de référence $2Q_R$ et le DLC envoie successivement sur la voie supérieure du diviseur de tension, c'est-à-dire sur la capacité $2^k C$, les tensions $-V_R$ et $-V_{Ri}$ avec i=1 à k—1.

Si on code la tension $V_x$ en utilisant douze coefficients $a_0$ à $a_n$, on prend généralement k égal à 6.

Les tensions $-V_R$ et $-V_{R1}$ à $V_{R5}$ sont donc successivement envoyées sur la capacité $2^6.C$.

La tension V en sortie, c'est-à-dire au point R du diviseur de tension capacitif, égale donc successivement:

$$V = -V_R \cdot \frac{2^6}{1 + 2^6 + C_p/C} = -V_R \cdot \frac{2^6}{K} \text{ avec } K = 1 + 2^6 + C_p/C \quad V = -V_{Ri} \cdot \frac{2^6}{K},$$

avec i=1 à 5, où $C_p$ représente la capacité parasite totale au point R qui est représentée en pointillés sur la figure 2.

Au cours de la deuxième étape, l'interrupteur $S_3$ est ouvert alors que l'interrupteur $S_4$ est fermé.

On remarque que la capacité $C_3$ de l'échantillonneur-bloqueur de la voie supérieure reste chargée à la dernière tension $-V_{R5}$ envoyée par le DLC au cours de la première étape.

On introduit dans le générateur une nouvelle quantité de charges de référence $2Q_R$ et le DLC envoie alors successivement sur la voie inférieure du diviseur de tension, c'est-à-dire sur la capacité C, les tensions $-V_R$ et $-V_{Ri}$ avec i=1 à n—k.

Avec l'exemple numérique cité précédemment où n égale 11 (puisqu'il y a 12 coefficients $a_0$ à $a_n$) et où k égale 6, ce sont les tensions $-V_R$ et $-V_{Ri}$, avec i=1 à 5 qui sont successivement envoyées sur la capacité C.

La tension V en sortie du diviseur égale donc successivement:

$$V = -V_{R5} \cdot \frac{2^6}{K} - V_R \cdot \frac{1}{K} \quad \text{et}$$

$$V = -V_{R5} \cdot \frac{2^6}{K} - V_{Ri} \cdot \frac{1}{K} \quad \text{, avec i=1 à 5.}$$

On peut constater que le deuxième terme de ces deux égalités est constitué par les tensions élaborées par le générateur lors de la deuxième étape qui sont multipliées par 1/K. Les tensions élaborées par le générateur lors de la deuxième étape sont donc divisées par $2^6$ par rapport à celles élaborées par le générateur lors de la première étape qui apparaissaient au point R multipliées par le coefficient $2^6/K$.

La tension V en sortie du diviseur peut donc s'écrire:

$$V = -V_{R5} \cdot \frac{2^6}{K} - \frac{V_R}{2^6} \cdot \frac{2^6}{K} = -V_{R6} \cdot \frac{2^6}{K}$$

$$V = -V_{R5} \cdot \frac{2^6}{K} - \frac{V_{Ri}}{\underbrace{2^6}} \cdot \frac{2^6}{K} = -V_{Ri} \cdot \frac{2^6}{K}$$

$$\underbrace{\qquad\qquad\qquad}_{i=1 \text{ à } 5} \qquad \underbrace{\qquad\qquad}_{i=7 \text{ à } 11}$$

On constate donc qu'au cours de la première étape, on obtient en sortie du diviseur au point R les tensions:

$$V = -V_R \cdot \frac{2^6}{K} \quad \text{et} \quad V = -V_{Ri} \cdot \frac{2^6}{K}$$

avec i=1 à 5 et qu'au cours de la deuxième étape, on obtient en sortie du diviseur au point R les tensions:

$$V = -V_{Ri} \cdot \frac{2^6}{K} \, ,$$

avec i=6 à 11.

Au coefficient $2^6/K$ près, on obtient donc les tensions $V_R$ et $V_{Ri}$, avec i=1 à 11 qui vont permettre la détermination des coefficients $a_0$ à $a_n$.

La sortie du diviseur de tension capacitif, c'est-à-dire le point R, est reliée en un point Q à la sortie d'un dispositif inverseur de polarité, constitué par un amplificateur pouvant prendre deux gains différents +1 et −1. Ce dispositif reçoit la tension à coder $V_x$. Dans un premier temps, le codeur selon l'invention détermine (nous verrons de quelle façon dans ce qui suit) le bit de signe $a_s$ de chaque échantillon $V_x$ à coder:

$$a_s = 1 \text{ si } V_x > 0$$

$$a = 0 \text{ so } v_x < 0$$

Dans le cas où $a_s = 0$, c'est-à-dire où $V_x$ est négatif, le dispositif inverseur reçoit l'ordre d'inverser la polarité de $V_x$ et prend le gain −1. En sortie du dispositif inverseur on trouve donc lorsque le bit du signe $a_s$ a été déterminé: $|V_x|$.

Au point Q, on obtient donc la tension:

$$|V_x| - V_R \cdot \frac{2^6}{K} \text{ et}$$

$$|V_x| - V_{Ri} \cdot \frac{2^6}{K}$$

avec i=1 à 11. Il est tout à fait aisé d'appliquer à $V_x$ le même coefficients $2^6/K$ qu'à $V_R$ et $V_{Ri}$; ceci peut être réalisé par un amplificateur à gain variable.

Au point Q est connecté un étage suiveur constitué de façon connue par un amplificateur différentiel A. Cet étage limite l'atténuation due à la capacité parasite $C_p$ au point Q et protège le point Q qui est un point flottant à haute impédance contre des parasites de commutation introduits par les interrupteurs $S_5$ et $S_6$.

A la sortie de l'étage suiveur sont connectés deux échantillonneurs-bloqueurs représentés de la même façon symbolique que les deux précédemment utilisés par un interrupteur, $S_5$ et $S_6$, suivi par une capacité connectée à la masse, $C_5$ et $C_6$.

Chaque échantillonneur-bloqueur est relié à l'une des deux entrées $e_1$ et $e_2$ d'un comparateur. Sur la figure 2, l'echantillonneur-bloqueur constitué par l'interrupteur $S_5$ et la capacité $C_5$ est relié à l'entée $e_1$ du comparateur.

Ce comparateur fournit un 1 si la tension appliquée à son entrée $e_1$ est supérieure à celle appliquée à son entrée $e_2$ et un 0 dans le cas contraire.

Ce comparateur est réalisé de façon tout à fait connue par un ensemble de transistors MOS et de capacités.

Enfin, la sortie du comparateur est reliée à une mémoire constituée par une bascule du type D ou un registre à décalage où sont stockées les valeurs du bit de signe $a_s$ puis des coefficients $a_0$ à $a_n$.

On va maintenant examiner la façon dont le bit de signe $a_s$ est déterminé.

L'inverseur de polarité de $V_x$ comporte deux interrupteurs $S_1$ et $S_2$. L'interrupteur $S_1$ se trouve en série avec l'entrée de l'inverseur et l'interrupteur $S_2$ est relié entre l'entrée de l'inverseur et la masse.

Pour la détermination de $a_s$, l'interrupteur $S_1$ est ouvert et l'interrupteur $S_2$ est fermé. L'entrée de

7

l'inverseur est donc court-circuitée. L'inverseur se trouve au gain +1 et envoie sa tension de décalage vers le point Q.

Par ailleurs, les interrupteurs $S_3$, $S_4$ et $S_6$ sont fermés alors que l'interrupteur $S_5$ est ouvert. Les signaux d'horloge sont appliqués au générateur de tension et au DLC mais l'injection des charges est bloquée. On charge donc la capacité $C_6$ avec les tensions de décalage des différents circuits du codeur, excepté le comparateur et la mémoire. Ces circuits sont le plus souvent réalisés en technologie MOS et il est particulièrement important de tenir compte des tensions de décalage.

De plus, en sortie du DLC, on a la tension moyenne $V_{PO}$ qui correspond au niveau moyen de polarisation du DLC avant l'introduction de la quantité de charges de référence $2Q_R$. Cette tension est appliquée à l'une des bornes des capacités $2^kC$ et C.

Une fois la capacité $C_6$ chargée, on ouvre les interrupteurs $S_2$ et $S_6$ et on ferme les interrupteurs $S_1$ et $S_5$. La tension moyenne $V_{PO}$ continue à être appliquée aux capacités $2^kC$ et C. La tension $V_x-V_{PO}$ ajoutée aux tensions de décalage charge la capacité $C_5$ et se trouve appliquée à l'entrée $e_1$ du comparateur qui en déduit le bit de signe $a_s$.

Dans le cas $a_s=0$ et où il est donc nécessaire de faire passer le gain de l'inverseur de +1 à −1, on décharge la capacité $C_6$ et on la charge à nouveau avec les tensions de décalage des différents circuits du codeur, avec cette fois le gain de l'inverseur à −1.

Lorsque la capacité $C_6$ est chargée avec ces tensions de décalage, on vérifie éventuellement que le bit de signe $a_s$ est bien égal à 0.

Une fois le bit de signe $a_s$ déterminé, on procède à l'introduction dans le générateur de tension codée d'une quantité de charges de référence $2Q_R$.

Avec les précautions prises, ce sont seulement les variations de tension en sortie du DLC par rapport à la polarisation initial $V_{PO}$ qui se trouvent reportées en Q; la valeur $V_{PO}$ n'intervient donc pas dans la détermination des coefficients pourvu qu'elle reste constante.

On va maintenant examiner la façon dont les coefficient $a_s...a_n$ sont déterminés.

On a vu précédemment qu'on obtenait au point Q les tensions

$$|V_x|-V_R \cdot \frac{2^6}{K} \text{ et}$$

$$|V_x|-V_{Ri} \cdot \frac{2^6}{K} \text{ avec } i=1 \text{ à } 11.$$

Les interrupteurs $S_2$ et $S_6$ sont ouverts, alors que les interrupteurs $S_1$ et $S_5$ sont fermés. D'autre part, selon qu'on se trouve pendant la première ou la deuxième étape d'élaboration des tensions $V_R$ et $V_{Ri}$ c'est l'interrupteur $S_3$ ou l'interrupteur $S_4$ qui est fermé.

$$\text{Les tensions } |V_x|-V_R \cdot \frac{2^6}{K} \text{ et}$$

$$|V_x|-V_{Ri} \cdot \frac{2^6}{K}$$

vont donc charger la capacité $C_5$, alors que la capacité $C_6$ est toujours chargée avec les tensions de décalage du codeur.

La capacité $C_5$ étant chargée par la tension

$$|V_x|-V_{Ri} \cdot \frac{2^6}{K} ,$$

on ouvre l'interrupteur $S_5$. Le comparateur détermine alors le coefficient $a_i$ qui est stocké en mémoire. L'information sur la valeur des coefficients est renvoyée vers le générateur. Pour $a_i=0$, la quantité de charges stockée sous $G_2$ est évacuée vers $D_e$ alors qu'elle est stockée sous $G_3$ pour contribuer à l'élaboration de $V_{Ri+1}$ si $a_i=1$. L'interrupteur $S_5$ est ensuite à nouveau fermé pour que $C_5$ soit chargée avec

$$|V_x|-V_{Ri+1} \cdot \frac{2^6}{K}$$

et que $a_{i+1}$ soit déterminé.

Tous les circuits du codeur, c'est-à-dire l'inverseur, les échantillonneurs-bloqueurs, le diviseur de tension capacitif, l'étage suivant, le comparateur et la mémoire sont de préférence réalisés en technologie N MOS ou C MOS compatible avec la réalisation du générateur de tension codée à transfert de charges. Ces circuits sont donc essentiellement constitués des éléments qu'on sait le mieux réaliser en technologie MOS, c'est-à-dire des capacités MOS et des transistors MOS. En particulier, tous les interrupteurs $S_1$ à $S_6$ sont constitués par un ou plusieurs transistors MOS.

Le codeur selon l'invention réalise le codage d'un signal analogique en numérique en utilisant une loi linéaire. En lui associant un transcodage numérique qui permet de passer d'une loi linéaire à une loi logarithmique, on peut réaliser par exemple un codeur logarithmique selon la loi A ou la loi $\mu$ normalisées pour le codage des signaux vocaux.

On a envisagé dans ce qui précède de réaliser un codage en deux étapes, mais il est bien entendu possible d'utiliser trois, quatre étapes ou plus généralement p étapes.

**Revendications**

1. Codeur analogique-numérique comportant un générateur de tension codée à transfert de charges, élaborant des tensions

$$V_R, V_{Ri} = a_0 V_R + a_1 . V_R/2 + a_2 . V_R/2^2 + \ldots a_n . V_R/2^n,$$

où $V_R$ est une tension de référence, ces tensions permettant par comparaison avec la tension à coder $V_x$ de déterminer par approximations successives les coefficients $a_0 \ldots a_n$, égaux à 0 ou à 1 et tels que

$$|V_x| = a_0 V_R + a_1 . V_R/2 + a_2 . V_R/2^2 \ldots + a_n . V_R/2^n,$$

caractérisé en ce que ce générateur est constitué par un dispositif à transfert de charges comportant en alternance des grilles de stockage et des grilles de transfert, avec:

— à une extrémité de la zone active où s'effectuent le transfert et le stockage des charges, une diode ($D_e$) qui assure, au début du traitement de chaque échantillon de la tension à coder $V_x$, l'injection d'une quantité de charges de référence $2Q_R$ et qui assure aussi l'évacuation des charges en surplus au cours du traitement:
— une diffusion d'isolement qui partage en deux parties égales les charges en provenance d'une première grille de stockage ($G_0$) située du côté de la diode ($D_e$) et qui divise la zone active après la première grille de stockage ($G_0$) en deux canaux parallèles;
— sur l'un desdits canaux, une deuxième grille de stockage ($G_1$) sous laquelle se trouvent stockées par des allers-retours successifs entre la première grille de stockage et la deuxième grille de stockage ($G_0$ et $G_1$) les quantités de charges, $Q_R$, $Q_R/2 \ldots$;
— sur l'autre desdits canaux, une troisième, quatrième et cinquième grille de stockage ($G_2$, $G_3$ et $G_4$), la quantité de charges $Q_R/2^i$ stockée sous la troisième grille de stockage ($G_2$) en provenance de la première grille de stockage ($G_0$) étant transférée sous la première grille de stockage ($G_0$) puis évacuée sous la diode ($D_e$) lorsque $a_i$ est nul, pour $i=0 \ldots n$, et étant transférée sous la quatrième grille de stockage ($G_3$), lorsque $a_i$ égale 1;—un dispositif de lecture des charges relié aux deuxième et cinquième grilles de stockage ($G_1$ et $G_4$) qui assure l'élaboration de $V_R$ lors du transfert de $Q_R$ sous la deuxième grille de stockage ($G_1$) ce qui permet la détermination de $a_0$ par comparaison de $V_R$ avec $V_x$, puis l'élaboration de $V_{R1} = a_0 Q_R + Q_R/2$, lors du transfert de $Q_R/2$ sous la deuxième grille de stockage ($G_1$) et lors de l'éventuel transfert, si $a_0=1$, de $Q_R$ en provenance de la quatrième grille de stockage ($G_3$) vers la cinquième grille de stockage ($G_4$) ce qui permet la détermination de $a_1$ par comparaison de $V_{R1}$ avec $V_x$, et ainsi de suite et en ce que la détermination par approximation successives des coefficients $a_0 \ldots a_n$, se fait en deux étapes:
— au cours de la première étape, après injection d'une quantité de charges de référence $2Q_R$, le générateur élabore les tensions

$$V_R \text{ et } V_{Ri} = a_0 . V_R + a_1 . V_R/2 \ldots a_{i-1} . V_R/2^{i-1} + V_R/2^i, \text{ avec } i=1 \text{ à } k-1;$$

— au cours de la deuxième étape, après injection d'une nouvelle quantité de charges de référence $2Q_R$, le générateur élabore les tensions $V_R$ et $V_{Ri}$ avec $i=1$ à $n-k$, le codeur comportant des moyens assurant d'une part la division par $2^k$ des tensions élaborées au cours de la deuxième étape et d'autre part leur sommation avec la dernière tension $V_{R(k-1)}$ produite lors de la première étape.

2. Codeur selon la revendication 1, caractérisé en ce que ces moyens sont constitués par:

— deux échantillonneurs-bloqueurs ($S_3$, $C_3$, $S_4$, $C_4$);
— un diviseur de tension capacitif à deux voies, chaque voie étant reliée à l'un des circuits d'échantillonnage et maintien et l'une des voies comportant une capacité de valeur $2^k$. C alors que l'autre

9

voie comporte une capacité de valeur C, les tensions élaborées par le générateur lors de la première étape étant envoyées sur la capacité de valeur $2^k C$ alors que les tensions élaborées par le générateur lors de la deuxième étape sont envoyées sur la capacité de valeur C.

3. Codeur selon la revendication 2, caractérisé en ce que le générateur comporte un dispositif de lecture des charges (DLC) qui fournit des tensions $-V_R$ et $-V_{Ri}$, avec i=1 à n.

4. Codeur selon la revendication 3, caractérisé en ce que la sortie du diviseur capacitif est reliée à la sortie d'un dispositif permettant d'inverser la polarité de la tension à coder $V_x$.

5. Codeur selon la revendication 4, caractérisé en ce qu'il comporte un comparateur à deux entrées $e_1$ et $e_2$ qui fournit un 1 si la tension appliquée à son entrée $e_1$ est supérieure à celle appliquée à son entrée $e_2$ et un zéro dans le cas contraire.

6. Codeur selon la revendication 5, caractérisé en ce que chaque entrée du comparateur est précédée par un échantillonneur-bloqueur ($S_5$, $C_5$, $S_6$, $C_6$), ces échantillonneurs-bloqueurs ayant un point commun relié à la sortie d'un étage suiveur (A) dont l'entrée est reliée au point commun (Q) aux sorties du diviseur capacitif et de l'inverseur.

7. Codeur selon l'une des revendications 1 à 6, caractérisé en ce qu'il est réalisé en technologie MOS.

8. Codeur selon la revendication 7, caractérisé en ce que la détermination du bit de signe $a_s$ de la tension $V_x$ se fait en deux étapes:

— au cours de la première étape, on charge avec les tensions de décalage des différents circuits la capacité ($C_6$) de l'échantillonneur-bloqueur ($S_6$, $C_6$) relié à l'entrée $e_1$ du comparateur;
— au cours de la deuxième étape, la tension $V_x$ charge la capacité ($C_5$) de l'échantillonneur-bloqueur ($S_5$, $C_5$) relié à l'entrée $e_2$ du comparateur.

9. Codeur selon la revendication 8, caractérisé en ce que les coefficients $a_0...a_n$ sont déterminés par le comparateur alors que la capacité ($C_5$) de l'échantillonneur-bloqueur ($S_5$, $C_5$) relié à l'entrée $e_1$ du comparateur est chargée par la tension $|V_x| - V_{Ri}$ et la capacité ($C_6$) de l'échantillonneur-bloqueur ($S_6$, $C_6$) relié à l'entrée $e_2$ du comparateur est chargée par les tensions de décalage.

10. Codeur selon l'une des revendications 1 à 9, caractérisé en ce qu'il est réalisé en technologie MOS à canal enterré.

11. Codeur selon l'une des revendications 1 à 10 caractérisé en ce que les deux canaux parallèles ont la même largeur.

12. Codeur selon l'une des revendications 1 à 11, caractérisé en ce que la diode ($D_e$) est suivie par un couple électrode de transfert ($T_0$)—électrode de stockage ($G_e$) qui reçoivent la même tension ($V_{GE}$), l'implantation sous l'électrode de transfert ($T_0$) étant adaptée pour que les courbes de potentiel de surface en fonction de la tension de ce couple de grilles soient parallèles et la diode ($D_e$) étant successivement portée à un niveau bas qui permet le passage des charges de la diode ($D_e$) sous l'électrode de transfert ($T_0$) et l'électrode de stockage ($G_e$) puis à un niveau haut qui permet de stocker la quantité de charges $2Q_R$ sous l'électrode de stockage ($G_e$).

13. Codeur selon l'une des revendications 1 à 12, caractérisé en ce qu'il comporte sur l'un des canaux à la suite de la cinquième grille de stockage ($G_4$) une diode ($D_c$) qui permet en fin de traitement l'évacuation des charges stockées sous la cinquième grille de stockage ($G_4$).

**Patentansprüche**

1. Mit Verschiebung von Ladungen arbeitender Analog/Digital-Codierer, der einen Generator zur Erzeugung einer codierten Spannung enthält, welcher die Spannungen

$$V_R, V_{Ri} = a_0 V_R + a_1 . V_R/2 + a_2 . V_R/2^2 + ... a_n . V_R/2^n$$

erzeugt, worin $V_R$ eine Bezugsspannung ist, wobei diese Spannungen durch Vergleichen mit der zu codierenden Spannung $V_x$ die Bestimmung der Koeffizienten $a_0...a_n$ durch sukzessive Approximationen ermöglichen, welche Koeffizienten gleich 0 oder gleich 1 und derart bestimmt sind, daß

$$|V_x| = a_0 V_R + a_1 . V_R/2 + a_2 . V_R/2^2 ... + a_n . V_R/2^n,$$

dadurch gekennzeichnet, daß dieser Generator gebildet ist aus einer Ladungsverschiebevorrichtung, welche miteinander abwechselnde Speicherelektroden und Überführungselektroden enthält, mit:

— an einem Ende der aktiven Zone, wo die Überführung und die Speicherung der Ladungen stattfindet, einer Diode ($D_e$), die am Anfang der Verarbeitung jeder Abtastprobe der zu codierenden Spannung $V_x$ die Einspeisung einer Bezugsladungsmenge $2Q_R$ gewährleistet und überdies die Abführung der überschüssigen Ladungen im Verlauf der Verarbeitung gewährleistet;
— einer isolierenden Diffundierung, welche die Ladungen in zwei gleiche Teile teilt, welche von einer

ersten Speicherelektrode ($G_0$) stammen, die auf der Seite der Diode ($D_e$) liegt und die aktive Zone hinter der ersten Speicherelektrode ($G_0$) in zwei parallele Kanäle teilt;
— auf einem dieser Kanäle eine zweite Speicherelektrode ($G_1$), unter welcher die Ladungsmengen $Q_R$, $Q_R/2$... durch aufeinanderfolgende Hin- und Rückläufe zwischen der ersten Speicherelektrode und der zweiten Speicherelektrode ($G_0$ und $G_1$) gespeichert sind;
— auf dem anderen dieser Kanäle eine dritte, eine vierte und eine fünfte Speicherelektrode ($G_2$, $G_3$ und $G_4$), wobei die unter der dritten Speicherelektrode ($G_2$) gespeicherte und von der ersten Speicherelektrode ($G_0$) herrührende Ladungsmenge $Q_R/2^i$ unter die erste Speicherelektrode ($G_0$) verschoben und anschließend unter die Diode ($D_e$) abgeführt wird, wenn $a_i$ gleich 0 ist, für $i=0...n$, und unter die vierte Speicherelektrode ($G_3$) verschoben wird, wenn $a_i$ gleich 1 ist;—einer Vorrichtung zum Auslesen von Ladungen, welche mit der zweiten und der fünften Speicherelektrode ($G_1$ und $G_4$) verbunden ist und die Erzeugung von $V_R$ während der Verschiebung von $Q_R$ unter die zweite Speicherelektrode ($G_1$) gewährleistet, wodurch die Bestimmung von $a_0$ durch Vergleichen von $V_R$ mit $V_x$ ermöglicht wird, und anschließend die Erzeugung von $V_{R1}=a_0 Q_R+Q_R/2$ ermöglicht wird, und zwar während der Überführung von $Q_R/2$ unter die zweite Speicherelektrode ($G_1$) und während der gegebenenfalls, wenn $a_0=1$, erfolgenden Überführung von $Q_R$, die von der vierten Speicherelektrode ($G_3$) stammt, zu der fünften Speicherelektrode ($G_4$), wodurch die Bestimmung von $a_1$ durch Vergleichen von $V_{R1}$ mit $V_x$ ermöglicht wird, usw., und daß die Bestimmung der Koeffizienten $a_0...a_n$ durch sukzessive Approximationen in zwei Stufen geschieht:
— während der ersten Stufe und nach Einspeisung einer Bezugsladungsmenge $2Q_R$ erzeugt der Generator die Spannungen

$$V_R \text{ und } V_{Ri}=a_0.V_R+a_1.V_R/2...a_{i-1}.V_R/2^{i-1}+V_R/2^i, \text{ mit } i=1 \text{ bis } k-1;$$

— im Verlauf der zweiten Stufe nach Einspeisung einer neuen Bezugsladungsmenge $2Q_R$ erzeugt der Generator die Spannungen $V_R$ und $V_{Ri}$, mit $i=1$ bis $n-k$, wobei der Codierer Mittel umfaßt, welche einerseits die Division der im Verlauf der zweiten Stufe erzeugten Spannungen durch $2^k$ gewährleisten und andrerseits ihre Summenbildung mit der letzten Spannung $V_{R(k-1)}$, die während der ersten Stufe erzeugt wurde, gewährleisten.

2. Codierer nach Anspruch 1, dadurch gekennzeichnet, daß diese Mittel gebildet sind durch:

— zwei Abtast- und Halteschaltungen ($S_3$, $C_3$, $S_4$, $C_4$);
— einen kapazitiven Spannungsteiler mit zwei Zweigen, worin jeder Zweig mit einer der Abtast- und Halteschaltungen verbunden ist und einer der Zweige eine Kapazität mit dem Wert $2^k$. C umfaßt, während der andere Zweig eine Kapazität mit dem Wert C besitzt, wobei die durch den Generator während der ersten Stufe erzeugten Spannungen auf die Kapazität mit dem Wert $2^kC$ gegeben werden, während die durch den Generator während der zweiten Stufe erzeugten Spannungen auf die Kapazität mit dem Wert C gegeben werden.

3. Codierer nach Anspruch 2, dadurch gekennzeichnet, daß der Generator eine Vorrichtung zum Auslesen von Ladungen (DLC) enthält, welche Spannungen $-V_R$ und $-V_{Ri}$ liefert, mit $i=1$ bis n.
4. Codierer nach Anspruch 3, dadurch gekennzeichnet, daß der Ausgang des kapazitiven Spannungsteilers mit dem Ausgang einer Vorrichtung verbunden ist, die eine Polaritätsumkehrung der zu codierenden Spannung $V_x$ ermöglicht.
5. Codierer nach Anspruch 4, dadurch gekennzeichnet, daß er einen Vergleicher mit zwei Eingängen $e_1$ und $e_2$ umfaßt, der eine 1 liefert, wenn die an seinen Eingang $e_1$ angelegte Spannung größer ist als die an seinen Eingang $e_2$ angelegte, und im entgegengesetzten Fall eine Null abgibt.
6. Codierer nach Anspruch 5, dadurch gekennzeichnet, daß jedem Eingang des Komparators eine Abtast- und Halteschaltung ($S_5$, $C_5$, $S_6$, $C_6$) vorausgeht, wobei diese Abtast- und Halteschaltungen einen gemeinsamen Punkt aufweisen, der mit dem Ausgang einer Folgerstufe (A) verbunden ist, deren Eingang mit dem gemeinsamen Punkt (Q) an den Ausgängen des kapazitiven Teilers und des Inverters verbunden ist.
7. Codierer nach einem der Ansprüche 1 bis 6, dadurch gekennzeichnet, daß er in MOS-Technologie verwirklicht ist.
8. Codierer nach Anspruch 7, dadurch gekennzeichnet, daß die Bestimmung des Vorzeichenbits $a_s$ der Spannung $V_x$ in zwei Stufen erfolgt:

— im Verlauf der ersten Stufe wird mit den Verschiebespannungen der verschiedenen Schaltungen die Kapazität ($C_6$) der Abtast- und Halteschaltung ($S_6$, $C_6$) aufgeladen, die an den Eingang $e_1$ des Komparators angeschlossen ist;
— im Verlauf der zweiten Stufe lädt die Spannung $V_x$ die Kapazität ($C_5$) der Abtast- und Halteschaltung ($S_5$, $C_5$) auf, welche mit dem Eingang $e_2$ des Komparators verbunden ist.

9. Codierer nach Anspruch 8, dadurch gekennzeichnet, daß die Koeffizienten $a_0...a_n$ durch den Komparator bestimmt werden, während die Kapazität ($C_5$) der mit dem Eingang $e_1$ des Komparators

verbundenen Abtast- und Halteschaltung ($S_5$, $C_5$) auf die Spannung $|V_x| - V_{Ri}$ aufgeladen wird und die Kapazität ($C_6$) der mit dem Eingang $e_2$ des Komparators verbundenen Abtast- und Halteschaltung ($S_6$, $C_6$) durch die Verschiebespannungen aufgeladen wird.

10. Codierer nach einem der Ansprüche 1 bis 9, dadurch gekennzeichnet, daß er in MOS-Technologie mit versenktem Kanal verwirklicht ist.

11. Codierer nach einem der Ansprüche 1 bis 10, dadurch gekennzeichnet, daß die beiden parallelen Kanäle dieselbe Breite aufweisen.

12. Codierer nach einem der Ansprüche 1 bis 11, dadurch gekennzeichnet, daß auf die Diode ($D_e$) ein Elektrodenpaar aus Verschiebeelektrode ($T_0$) und Speicherelektrode ($G_e$) folgt, welche dieselbe Spannung ($V_{Ge}$) empfangen, wobei die Implantation unter der Verschiebeelektrode ($T_0$) so ausgelegt ist, daß die Kurven des Oberflächenpotentials in Abhängigkeit von der Spannung dieses Elektrodenpaars parallel sind, und wobei die Diode ($D_e$) nacheinander auf einen niedrigen Pegel, der die Beförderung der Ladungen von der Diode ($D_e$) unter die Verschiebeelektrode ($T_0$) und die Speicherelektrode ($G_e$) ermöglicht, und auf einen hohen Pegel gebracht wird, durch den die Ladungsmenge $2Q_R$ unter der Speicherelektrode ($G_e$) gespeichert werden kann.

13. Codierer nach einem der Ansprüche 1 bis 12, dadurch gekennzeichnet, daß er auf einem der Kanäle und hinter der fünften Speicherelektrode ($G_4$) eine Diode ($D_c$) aufweist, durch die am Ende der Verarbeitung die Abführung der unter der fünften Speicherelektrode ($G_4$) gespeicherten Ladungen ermöglicht wird.

**Claims**

1. Charge transfer analog/digital coder comprising a generator of coded voltages producing the voltages

$$V_R, V_{Ri} = a_0 V_R + a_1.V_R/2 + a_2.V_R/2^2 + \dots a_n.V_R/2^n,$$

wherein $V_R$ is a reference voltage, said voltages permitting by comparison with the voltage $V_x$ to be coded the determination of the coefficients $a_0 \dots a_n$ by successive approximations, equal to 0 or 1 and such that

$$|V_x| = a_0 V_R + a_1.V_R/2 + a_2.V_R/2^2 \dots + a_n.V_R/2^n,$$

characterized in that said generator is formed by a charge transfer device comprising in alternation storage electrodes and transfer electrodes, with:

— at one end of the active zone where the transfer and storage of the charges is effected a diode ($D_e$) which ensures at the start of the processing of each sample of the voltage $V_x$ to be coded the feeding in of a reference charge quantity $2Q_R$ and also ensures the evacuation of the excess charges in the course of the processing;

— an insulating diffusion which divides into two equal parts the charges originating from a first storage electrode ($G_0$) situated on the side of the diode ($D_e$) and which divides the active zone behind the first storage electrode ($G_0$) into two parallel channels;

— on one of said channels a second storage electrode ($G_1$) under which the charge quantities $Q_R$, $Q_R/2 \dots$ are stored by successive goings and returns between the first storage electrode and the second storage electrode ($G_0$ and $G_1$);

— on the other of said channels a third, a fourth and a fifth storage electrode ($G_2$, $G_3$ and $G_4$), the charge quantity $Q_R/2^i$ stored under the third storage electrode ($G_2$) and originating from the first storage electrode ($G_0$) being transferred under the first storage electrode ($G_0$) and then evacuated under the diode ($D_e$) when $a_i$ is equal to 0, for $i=0 \dots n$, and being transferred under the fourth storage electrode ($G_3$) when $a_i$ is equal to 1;—a device for reading charges connected to the second and the fifth storage electrodes ($G_1$ and $G_4$) which ensures the production of $V_R$ during the transfer of $Q_R$ under the second storage electrode ($G_1$), which permits the determination of $a_0$ by comparison of $V_R$ with $V_x$, and thereafter the production of $V_{R1} = a_0 Q_R + Q_R/2$ during the transfer of $Q_R/2$ under the second storage electrode ($G_1$) and during the possible transfer, if $a_0=1$, of $Q_R$ originating from the fourth storage electrode ($G_3$) to the fifth storage electrode ($G_4$), which permits the determination of $a_1$ by comparison of $V_{R1}$ with $V_x$, and so on, and that the determination of the coefficients $a_0 \dots a_n$ is effected by successive approximations in two stages:

— during the first stage after the injection of a reference charge quantity $2Q_R$ the generator produces the voltages

$$V_R \text{ and } V_{Ri} = a_0.V_R + a_1.V_R/2 \dots a_{i-1}.V_R/2^{i-1} + V_R/2^i, \text{ with } i=1 \text{ to } k-1;$$

— during the second stage after injection of a new reference charge quantity $2Q_R$ the generator produces the voltages $V_R$ and $V_{Ri}$ with $i=1$ to $n-k$, the coder comprising means ensuring on the one hand the division by $2^k$ of the voltages produced during the second stage and on the other hand their summation with the last voltage $V_{R(k-1)}$ produced during the first stage.

2. Coder according to claim 1, characterized in that said means are formed by:

— two sample and hold devices ($S_3$, $C_3$, $S_4$, $C_4$);

— a capacitive voltage divider with two branches, each branch being connected to one of the sample and hold circuits and one of the branches comprising a capacitance of value $2^k$. C whilst the other branch comprises a capacitance of value C, the voltages produced by the generator during the first stage being applied on the capacitance of value $2^kC$ whilst the voltages produced by the generator during the second stage are applied on the capacitance with the value C.

3. Coder according to claim 2, characterized in that the generator comprises a device for reading the charges (DLC) which furnishes voltages $-V_R$ and $-V_{R1}$ with i=1 to n.

4. Coder according to claim 3, characterized in that the output of the capacitive divider is connected to the output of a device permitting inversion of the polarity of the voltage $V_x$ to be coded.

5. Coder according to claim 4, characterized in that it comprises a comparator having 2 inputs $e_1$ and $e_2$ which furnishes a 1 when the voltage applied to its input $e_1$ is greater than that applied to its input $e_2$ and a zero in the opposite case.

6. Coder according to claim 5, characterized in that each input of the comparator is preceded by a sample and hold device ($S_5$, $C_5$, $S_6$, $C_6$), said sample and hold devices having a common point connected to the output of a follower stage (A) whose input is connected to the common point (Q) at the outputs of the capacitive divider and the inverter.

7. Coder according to one of claims 1 to 6, characterized in that it is realized in MOS technology.

8. Coder according to claim 7, characterized in that the determination of the sign bit $a_s$ of the voltage $V_x$ takes place in two stages:

— in the course of the first stage the capacitance ($C_6$) of the sample and hold device ($S_6$, $C_6$) connected to the input $e_1$ of the comparator is charged with the displacement voltages of the various circuits;

— in the course of the second stage the voltage $V_x$ charges the capacitance ($C_5$) of the sample and hold device ($S_5C_5$) connected to the input $e_2$ of the comparator.

9. Coder according to claim 8, characterized in that the coefficients $a_0...a_n$ are determined by the comparator whilst the capacitance ($C_5$) of the sample and hold device ($S_5C_5$) connected to the input $e_1$ of the comparator is charged to the voltage $|V_x| -V_{Ri}$ and the capacitance ($C_6$) of the sample and hold device ($S_6$, $C_6$) connected to the input $e_2$ of the comparator is charged by the displacement voltages.

10. Coder according to any one of claims 1 to 9, characterized in that it is realized in MOS technology with buried channel.

11. Coder according to any one of claims 1 to 10, characterized in that the two parallel channels have the same width.

12. Coder according to any one of claims 1 to 11, characterized in that the diode is followed by an electrode pair comprising transfer electrode ($T_0$) and storage electrode ($G_e$) which receive the same voltage ($V_{Ge}$), the implantation under the transfer electrode ($T_0$) being adapted so that the curves of the surface potential in dependence upon the voltage of said electrode pair are parallel and the diode ($D_e$) is successively brought to a low level which permits the passage of the charges of the diode ($D_e$) under the transfer electrode ($T_0$) and the storage electrode ($G_e$) and to a high level by which the charge quantity $2Q_R$ can be stored under the storage electrode ($G_e$).

13. Coder according to any one of claims 1 to 12, characterized in that it comprises on one of the channels and behind the fifth storage electrode ($G_4$) a diode ($D_c$) which permits at the end of the processing the evacuation of the charges stored under the fifth storage electrode ($G_4$).

# FIG_1

FIG_2